(19) Europäisches Patentamt
European Patent Office
Office européen des brevets

(11) **EP 4 030 780 B1**

(12) **EUROPÄISCHE PATENTSCHRIFT**

(45) Veröffentlichungstag und Bekanntmachung des Hinweises auf die Patenterteilung:
**24.07.2024   Patentblatt 2024/30**

(21) Anmeldenummer: **21215473.6**

(22) Anmeldetag: **17.12.2021**

(51) Internationale Patentklassifikation (IPC):
**H04R 1/10** *(2006.01)*     **H04R 25/00** *(2006.01)*

(52) Gemeinsame Patentklassifikation (CPC):
**H04R 1/1025; H04R 25/55;** H04R 2225/31;
H04R 2225/51

(54) **HÖRVORRICHTUNG UND PLATINE FÜR EINE HÖRVORRICHTUNG**

HEARING AID AND CIRCUIT BOARD FOR A HEARING AID

DISPOSITIF AUDITIF ET PLATINE POUR UN DISPOSITIF AUDITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.01.2021   DE 102021200249**

(43) Veröffentlichungstag der Anmeldung:
**20.07.2022   Patentblatt 2022/29**

(73) Patentinhaber: **Sivantos Pte. Ltd.**
**Singapore 539775 (SG)**

(72) Erfinder:
• **NARAMPANAWE, Nishshanka Bandara**
**649491 Singapore (SG)**
• **YAP, Heng Goh**
**338521 Singapore (SG)**
• **ONG, Chuan En Andrew**
**680157 Singapore (SG)**
• **RATHNAYAKA MUDIYANSELAGE, Sooriya Bandara**
**738968 Singapore (SG)**

(74) Vertreter: **FDST Patentanwälte**
**Nordostpark 16**
**90411 Nürnberg (DE)**

(56) Entgegenhaltungen:
KR-A- 20200 030 786     US-A1- 2013 089 232
US-A1- 2013 127 404     US-A1- 2013 175 983
US-A1- 2014 176 060     US-A1- 2020 021 127

EP 4 030 780 B1

**Beschreibung**

Die Erfindung betrifft eine Hörvorrichtung sowie eine Platine hierfür.

Eine Hörvorrichtung dient üblicherweise zur Ausgabe eines Audiosignals an einen Nutzer der Hörvorrichtung. Die Ausgabe erfolgt dabei mittels eines Ausgabewandlers, meist auf akustischem Weg über Luftschall mittels eines sogenannten Hörers, welcher auch als Lautsprecher oder Receiver bezeichnet wird. Eine spezielle Ausgestaltung einer Hörvorrichtung ist ein Hörhilfegerät, kurz auch als Hörgerät bezeichnet, zur Versorgung eines Nutzers mit einem Hördefizit. Dazu weist die Hörvorrichtung normalerweise wenigstens einen akustischen Eingangswandler, typischerweise ein Mikrofon, und einen Signalprozessor auf. Der Signalprozessor ist dazu ausgebildet, ein Eingangssignal, welches von dem Eingangswandler aus Umgebungsschall erzeugt wird, zu verarbeiten und dadurch das Hördefizit des Nutzers zumindest teilweise auszugleichen. Speziell bei einem Hörgerät ist auch eine Variante möglich, bei welcher der Ausgabewandler neben ein sogenannter Knochenleitungshörer oder ein Cochlea-Implantat ist, zur mechanischen oder elektrischen Einkopplung des Audiosignals in das Gehör des Nutzers. Unter den allgemeinen Begriff "Hörvorrichtung" fallen zusätzlich insbesondere auch Geräte wie z.B. sogenannte Tinnitus-Masker, Headsets, Kopfhörer und dergleichen.

Zur Energieversorgung elektronischer Komponenten, insbesondere Ausgabewandler, Signalprozessor etc., der Hörvorrichtung ist die Verwendung eines wiederaufladbaren Energiespeichers vorteilhaft, speziell in Form von Sekundärzellen, welche auch als "Akkus" bezeichnet werden. Grundsätzlich ist es dabei denkbar, herkömmliche Batterieformate durch gleichformatige Sekundärzellen zu ersetzen. Da letztere jedoch häufig andere Spannungswerte ausgeben, ist zur Spannungswandlung regelmäßig als Teil der Hörvorrichtung eine Wandlerelektronik erforderlich, um die benötigten Spannungswerte für die elektronischen Komponenten zu realisieren, sodass ein bloßer Austausch meist nicht möglich ist. Außerdem soll ein Wiederaufladen der Sekundärzellen auch ohne deren Entnahme aus der entsprechenden Hörvorrichtung möglich sein, um den Nutzungskomfort zu erhöhen. Da Hörvorrichtungen regelmäßig am Körper getragen werden und somit Körperflüssigkeiten, insbesondere Schweiß ausgesetzt sind, ist außerdem ein kontaktloses und speziell kabelloses Laden wünschenswert, sodass dann das Gehäuse der Hörvorrichtung besonders dicht gegenüber Umwelteinflüssen, insbesondere feuchtigkeitsdicht gestaltbar ist.

Ein kontaktloses Laden ist induktiv mittels einer Ladespule der Hörvorrichtung möglich, welche in einem Ladebetrieb mit einer Sendespule induktiv gekoppelt ist, welche ein Teil eines Ladegeräts für die Hörvorrichtung ist. Unter "kontaktlos" wird allgemein verstanden, dass das Laden gerade keine galvanische Verbindung zwischen Ladegerät und Hörvorrichtung erfordert. Eine einfache mechanische Kopplung z.B. zwecks Halterung der Hörvorrichtung am Ladegerät speziell während des Ladens ist dabei aber möglich. Die Ladespule wird auch als "Empfangsspule" oder "Sekundärspule" bezeichnet, die Sendespule auch als "Primärspule". Hierbei ist als Teil der Hörvorrichtung allerdings eine Ladeelektronik zur Steuerung des Ladevorgangs erforderlich, gegebenenfalls zusätzlich zu einer Wandlerelektronik wie bereits beschrieben. Diese Ladeelektronik wird regelmäßig gemeinsam mit der Sekundärzelle in einem sogenannten Batteriemodul der Hörvorrichtung kombiniert.

Für induktives Laden ist eine möglichst genaue relative Ausrichtung der Ladespule zu der Sendespule wünschenswert. Weiterhin sollten die beiden Spulen auch mit möglichst geringem Abstand zueinander angeordnet sein, z.B. im Abstand weniger Millimeter, z.B. 3 mm. Ansonsten wird die mögliche Energieausbeute bei der Energieübertragung beeinträchtigt, was zu langen Ladezyklen oder einer unzureichenden Aufladung führt.

Verschiedene Empfangsspulen sind gezeigt in US 2014/176060 A1, US 2013/175983 A1, US 2013/127404 A1, US 2020/021127 A1, KR 2020 0030786 A und US 2013/089232 A1.

Der Erfindung liegt die Aufgabe zugrunde, ein kontaktloses Laden einer Sekundärzelle in einer Hörvorrichtung zu verbessern.

Die Aufgabe wird erfindungsgemäß gelöst durch eine Hörvorrichtung mit den Merkmalen gemäß Anspruch 1 sowie durch eine Platine mit den Merkmalen gemäß Anspruch 9. Vorteilhafte Ausgestaltungen, Weiterbildungen und Varianten sind Gegenstand der Unteransprüche.

Die Hörvorrichtung weist ein Batteriemodul auf. Das Batteriemodul ist insbesondere in einem Gehäuse der Hörvorrichtung untergebracht. Das Batteriemodul weist eine Sekundärzelle auf, welche insbesondere zur Energieversorgung einer oder mehrerer Komponenten der Hörvorrichtung dient. Das Batteriemodul weist weiter eine Empfangsspule auf, zum kontaktlosen Laden der Sekundärzelle. Die Empfangsspule wird daher auch als Ladespule bezeichnet.

Unter "kontaktlos" wird allgemein verstanden, dass das Laden gerade keine galvanische Verbindung zwischen Ladegerät und Hörvorrichtung erfordert. Eine einfache mechanische Kopplung z.B. zwecks Halterung der Hörvorrichtung am Ladegerät speziell während des Ladens ist dabei aber möglich. Das kontaktlose Laden erfolgt in einem Ladebetrieb für die Hörvorrichtung vorzugsweise per Magnetfeld in einem induktiven Resonanzladeverfahren, sodass das kontaktlose Laden dann ein induktives Laden ist. Zum kontaktlosen Laden wird ein Ladegerät verwendet, mit einer Sendespule, welche auch als "Primärspule" bezeichnet wird. Entsprechend wird die Empfangsspule auch als "Sekundärspule" bezeichnet. Die Empfangsspule und die Sendespule werden jeweils allgemein auch als Spule bezeichnet. Beim Laden wird über die Spulen Energie vom Ladegerät zur Hörvorrichtung übertragen und auf diese Weise die Sekundärzelle geladen.

Zumindest das Gehäuse, vorzugsweise sogar die Hörvorrichtung insgesamt, wird bei bestimmungsgemäßer Verwendung insbesondere vollständig im Bereich des Kopfes des Anwenders getragen, vorzugsweise seitlich des Kopfes und im, am oder hinter dem Ohr. Die Hörvorrichtung ist entsprechend kompakt, sodass sich an diese und deren einzelne Komponenten entsprechende Anforderung ergeben, nämlich eine möglichst kompakte Bauform und eine möglichst effiziente Nutzung von Bauraum.

Das Batteriemodul weist weiter eine Platine auf, mit einer Leiterbahn, welche die Empfangsspule bildet. Die Platine wird auch als Leiterplatte oder gedruckte Schaltung (kurz PCB, für "printed circuit board") bezeichnet. Die Leiterbahn ist insbesondere aus einem leitenden Material gefertigt, vorzugsweise Kupfer, und auf einem Substrat der Platine aufgetragen oder in das Substrat eingebettet oder beides.

Die Platine weist zudem mehrere Lagen auf, wobei eine einzelne Lage (Englisch: layer) auch als Schicht bezeichnet wird. Der Begriff "Lage" kennzeichnet insbesondere eine einzelne Ebene, welche eine oder mehrere Leiterbahnen trägt. Die Platine ist demnach eine mehrlagige Platine mit wenigstens zwei Lagen. Beispielsweise bilden eine Oberseite und eine Unterseite der Platine jeweils eine Lage, sodass die Platine eine doppelseitige Platine ist. Oder die Platine weist mehr als zwei Lagen auf und ist dann eine sogenannte Mehrlagenplatine. Die Lagen sind in einer Stapelrichtung übereinandergestapelt. Die Platine ist insgesamt insbesondere flach, d.h. plattenartig, ausgebildet und weist vorzugsweise eine Dicke im Bereich von 0,5 mm bis 5 mm auf. Die Dicke der Platine ist in Stapelrichtung gemessen, d.h. senkrecht zu den Lagen. Die Platine kann grundsätzlich plan ausgebildet oder umgeknickt, verläuft also nicht zwingend entlang einer einzelnen, planen Ebene, sondern folgt je nach Ausgestaltung der Hörvorrichtung einem gebogenen oder umknickenden Verlauf, z.B. um sich einer Kontur im oder am Gehäuse oder einer Komponente der Hörvorrichtung anzupassen. Besonders bevorzugt ist die Platine flexibel, d.h. biegsam und elastisch, um z.B. einem gebogenen Verlauf zu folgen.

Die Leiterbahn erstreckt sich über die mehreren Lagen und weist dabei in jeder der mehreren Lagen eine Leiterschleife auf, mit wenigstens einer Windung. Auf diese Weise wird die Empfangsspule gebildet, mit entsprechend vielen Windungen. Die konkreten Abmessungen der Windungen und deren Anordnung bestimmen die Übertragungseigenschaften der Empfangsspule. Vorzugsweise sind die Leiterschleifen der unterschiedlichen Lagen überwiegend gleichartig ausgebildet und weiter vorzugsweise in Stapelrichtung betrachtet überwiegend zur Deckung gebracht. Dabei wird unter "überwiegend" insbesondere "zu wenigstens 90%" verstanden. Wie auch die Platine, so ist auch die Leiterbahn vorzugsweise flexibel und hierzu insbesondere als flache Bahn ausgebildet.

Eine Windung ist dadurch gekennzeichnet, dass diese vollständig innerhalb einer einzelnen Lage verläuft. Weiter ist eine Windung dadurch gekennzeichnet, dass diese eine offene Schlaufe bildet, d.h. insbesondere einen Freiraum (auch Innenbereich) möglichst vollständig umringt und dabei jedoch nicht geschlossen ist. Eine jeweilige Windung weist demnach zwei Enden auf, welche nicht miteinander verbunden sind, jedoch vorzugsweise seitlich innerhalb der Lage nebeneinander liegen. Die Windung ist vorzugsweise rechteckig, alternativ jedoch rund oder anders geformt.

Ein Kerngedanke der Erfindung ist insbesondere die Verwendung einer Platine mit einer speziell ausgebildeten Leiterbahn. Die Leiterbahn ist dabei als Spule ausgebildet, indem die Leiterbahn mehrere Leiterschleifen bildet, welche auf unterschiedliche Lagen der Platine verteilt sind. Dadurch wird auf einfache und kompakte Weise eine Empfangsspule für ein kontaktloses Laden realisiert. Die Verwendung einer Leiterbahn als Empfangsspule führt aufgrund der besonders flachen Ausgestaltung zu einem besonders günstigen Formfaktor, bei welchem die Empfangsspule insgesamt besonders flach ist und dabei regelmäßig flacher als aus Draht gewickelte Spulen mit ähnlichen Übertragungseigenschaften. Speziell wird bei einer Platine vermieden, dass ein endseitiger Überlapp der Leiterbahn zu einer Verdickung führt, wie dies bei einer Spule aus Draht der Fall ist, bei welcher eines der Drahtenden aus dem Inneren der Spule zum Anschließen nach außen geführt werden muss. Außerdem sind Leiterbahnen von Platinen reproduzierbar mit besonders hoher Genauigkeit herstellbar und eignen sich damit besonders für eine Massenfertigung. Typischerweise lassen sich Leiterbahnen reproduzierbar mit einer Toleranz von weniger als 10 $\mu$m fertigen. Im Vergleich dazu ist die Herstellung von z.B. handgewickelten Spulen deutlich ungenauer und die Spulen weisen stärkere Abweichungen untereinander auf. Aber auch maschinengewickelte Spulen weisen untereinander zuweilen Abweichungen auf, welche größer sind als bei der Herstellung einer Leiterbahn. Zwei grundsätzlich gleichartig auf Basis eines Drahts hergestellte Spulen weisen damit nicht zwangsläufig die gleichen Übertragungseigenschaften auf. Daraus ergeben sich auch unterschiedliche Resonanzfrequenzen. Um dies auszugleichen, kann ein Ausgleichskondensator (Englisch: tuning capacitor) verwendet werden, mit welchem die Resonanzfrequenz nachträglich korrigiert wird. Dies erfordert jedoch ein zusätzliches Bauteil und auch einen erhöhten Aufwand, da die nötige Kapazität und der entsprechende Kondensator für jede Spule neu bestimmt und ausgewählt werden müssen. Dies wirkt sich nachteilig auf Kosten und Geschwindigkeit bei der Herstellung aus.

Vorzugsweise bilden die Leiterschleifen zusammen eine Helix und die Windungen einer jeweiligen Leiterschleife bilden eine Spirale, sodass die Empfangsspule als spiral-planare, helixförmige Spule ausgebildet ist. Die Windungen einer jeweiligen Leiterschleife bilden dann innerhalb der entsprechenden Lage eine Spirale. Dadurch, dass sich die Leiterbahn über mehrere Lagen erstreckt, ist dann eine Helix ausgebildet. Insgesamt sind also mehrere Spiralen in Stapelrichtung übereinander angeordnet und miteinander derart in Reihe verbunden, dass eine Helix gebildet wird.

Hierzu ist eines von zwei Enden einer jeweiligen Spirale mit einem Ende einer Spirale der darüberliegenden Leiterschleife verbunden und das andere der zwei Enden mit einem Ende einer Spirale der darunterliegenden Leiterschleife. Zur Ausbildung einer Helix werden wenigstens zwei Leiterschleifen, d.h. zwei Lagen benötigt. Zur Ausbildung einer Spirale werden wenigstens zwei Windungen innerhalb einer Lage benötigt. Die spiral-planare, helixförmige Ausgestaltung der Spule vereint die Vorteile einerseits einer besonders großen Induktivität und andererseits einer besonders kompakten Bauform.

In einer besonders bevorzugten Ausgestaltung weist die Empfangsspule genau zwei Leiterschleifen mit jeweils genau zwei Windungen auf, sodass insgesamt vier Windungen vorhanden sind, welche auf zwei Lagen verteilt sind. Diese Ausgestaltung ist besonders geeignet für Hörgeräte. Außerdem ist die Herstellung bei lediglich zwei Lagen besonders einfach, indem einfach je auf Ober- und Unterseite der Platine eine Leiterschleife ausgebildet wird.

Geeigneterweise sind die Leiterschleifen mittels einer Durchkontaktierung leitend verbunden und seriell verschaltet. Die Durchkontaktierung wird aus als "via" bezeichnet. Die Durchkontaktierung ist insbesondere in das Substrat der Platine eingebettet, z.B. als Loch mit metallisierter Innenwand oder mit darin eingesetzter Metallhülse, und reicht so von einer Lage zur benachbarten Lage. Die Durchkontaktierung erstreckt sich insbesondere in Stapelrichtung und somit senkrecht zu den Lagen. Je zwei Leiterschleifen sind mit einer Durchkontaktierung leitend verbunden, sodass sich insgesamt eine Reihenschaltung der Leiterschleifen ergibt. Die Anzahl an Durchkontaktierungen ist dann um eins geringer als die Anzahl an Leiterschleifen.

Aufgrund der Windungen weist eine jeweilige Leiterschleife insbesondere ein inneres Ende und ein äußeres Ende auf und mittels einer jeweiligen Durchkontaktierung sind dann immer zwei innere Enden oder zwei äußere Enden miteinander verbunden. Die zwei verbleibenden Enden der obersten und untersten Leiterschleife sind dann mit je einem Anschlusskontakt verbunden, zum Anschließen der Spule z.B. an die Sekundärzelle, an eine Wandlerelektronik, an eine Ladeelektronik oder eine Kombination hiervon.

Generell weist die Platine zwei Anschlusskontakte auf, welche je mit einem Ende der Leiterbahn verbunden sind, um die Empfangsspule anzuschließen. Die Anschlusskontakte sind vorzugsweise gemeinsam in einer der Lagen der Platine angeordnet, insbesondere ist hierzu für zumindest einen der Anschlusskontakte eine Durchkontaktierung vorhanden, welche diesen Anschlusskontakt mit einem Ende der Leiterbahn in einer anderen Lage verbindet.

Vorzugsweise weist die Hörvorrichtung eine Ladeelektronik auf, zur Steuerung des Ladevorgangs für die Sekundärzelle. In einer geeigneten Ausgestaltung weist die Hörvorrichtung alternativ oder zusätzlich eine Wandlerelektronik auf, zur Spannungswandlung, um geeignete Spannungswerte für die elektronischen Komponenten zu realisieren. Die Ladeelektronik oder die Wandlerelektronik oder beide sind insbesondere als integrierte Schaltungen oder Schaltkreise oder in vergleichbarer Weise als Teil der Platine realisiert und somit Teil des Batteriemoduls.

Bevorzugterweise weist die Leiterbahn eine Breite im Bereich von 200 $\mu$m bis 500 $\mu$m auf und eine Dicke im Bereich von 10 $\mu$m bis 100 $\mu$m. Diese Abmessungen ergeben besonders geeignete Übertragungseigenschaften. Die Leiterbahn weist vorzugsweise einen rechteckigen Querschnitt auf, wobei dann die Breite entlang der Lage gemessen ist und die Dicke senkrecht zur Lage.

Die nachfolgende Tabelle 1 beschreibt sechs vorteilhafte Ausgestaltungen A - F der Empfangsspule und deren Übertragungseigenschaften, welche mittels einer Simulation ermittelt wurden:

| Ausgestaltung | Anzahl an Lagen | Anzahl an Win- dungen | Breite der Leiter- bahn [mm] | Dicke der Leiter- bahn [μm] | Induktivität [nH] | Widerstand [mΩ] | Q-Faktor |
|---|---|---|---|---|---|---|---|
| A | 2 | 4 | 0,3 | 70 | 137 | 390 | 29,3 |
| B | 2 | 4 | 0,3 | 35 | 149 | 450 | 27,9 |
| C | 2 | 4 | 0,3 | 17,5 | 156 | 550 | 23,8 |
| D | 2 | 4 | 0,4 | 70 | 113 | 350 | 29,1 |
| E | 2 | 4 | 0,4 | 35 | 123 | 380 | 27,4 |
| F | 4 | 4 | 0,3 | 18,12,12,18 | 140 | 550 | 22 |

Tabelle 1

Alle sechs Ausgestaltungen A - F gemäß Tabelle 1 weisen eine Leiterbahn mit vier Windungen auf. In der Ausgestaltung F ist jede Windung in einer eigenen Lage angeordnet, wohingegen in den Ausgestaltungen A - E jeweils zwei Lagen ausgebildet sind, mit je einer Leiterschleife mit zwei Windungen. Die Breite der Leiterbahn beträgt 0,3 mm für die Ausgestaltungen A, B, C, F und ansonsten 0,4 mm. Die Dicke der Leiterbahn ist in den Ausgestaltungen A - E jeweils gleich für alle jeweiligen Leiterschleifen, in der Ausgestaltung F hingegen weisen die Leiterschleifen der mittleren beiden Lagen eine geringe Dicke auf als die Leiterschleifen der äußeren Lagen. Die letzte Spalte gibt den Q-Faktor, d.h. Qualitätsfaktor, der Empfangsspule an. Der Q-Faktor, kurz "Q", bestimmt auch die Güte der Kopplung zwischen den beiden Spulen.

Der Q-Faktor ist abhängig von den Abmessungen der Leiterbahn. Insbesondere weist die Leiterbahn einen Querschnitt auf, welcher den Widerstand, genauer gesagt den Wechselstromwiderstand (Englisch: AC resistance, bezeichnet mit Rac), der Leiterbahn bestimmt. Eine Verringerung des Querschnitts führt üblicherweise zu einer Vergrößerung des Widerstands. Daher ist grundsätzlich ein großer Querschnitt vorteilhaft, d.h. eine große Breite, da die Dicke aufgrund der Schichtstruktur und der Herstellung der Platine typischerweise weniger flexibel wählbar ist, als die Breite. Der Querschnitt ergibt sich als Produkt von Breite und Höhe, z.B. von Breite und Höhe wie oben in Tabelle 1 angegeben. Der Widerstand $R_{AC}$ ist frequenzabhängig und ergibt sich gemäß folgender Gleichung:

$$R_{AC}(f) = [\,(2.16 \times 10^{-7})\,\sqrt{(f \cdot \rho_R)}\,]\,/\,[\,2(w + d)\,]$$

Dabei ist w die Breite, d die Dicke der Leiterbahn, f die Frequenz in Hz, $\rho_R$ der relative, spezifische Widerstand der Leiterbahn im Vergleich zu Kupfer mit $\rho_R = 1$. Bei gleichen Außenabmessungen einer Leiterschleife ergibt sich bei geringerer Breite jedoch eine größere Freifläche, welche von der Leiterschleife umringt wird, und damit eine höhere Induktivität der Spule. Entsprechend muss eine Abwägung vorgenommen werden, zwischen einem möglichst geringen Widerstand einerseits und einer möglichst großen Induktivität andererseits.

Wie sich aus obiger Tabelle 1 entnehmen lässt, ergeben sich bei gleicher Dicke aber unterschiedlicher Breite sowohl eine höhere Induktivität als auch ein höherer Widerstand für die Ausgestaltungen mit geringerer Breite, vgl. z.B. Ausgestaltungen A und D oder B und E. Der Unterschied im Q-Faktor ist dabei jedoch unwesentlich.

Eine unterschiedliche Dicke bei ansonsten gleicher Ausgestaltung ergibt gemäß Tabelle 1 für eine geringere Dicke eine geringere Induktivität, jedoch einen signifikant erhöhten Widerstand, was in Kombination einen großen Einfluss auf den Q-Faktor hat. Demnach ist eine möglichst große Dicke bevorzugt, da dies zu einem größeren Q-Faktor führt, vgl. z.B. Ausgestaltungen A, B, C.

Schließlich zeigt Tabelle 1, dass Ausgestaltungen mit zwei Lagen (Ausgestaltungen A - E ) gegenüber Ausgestaltungen mit vier Lagen (Ausgestaltung F) bevorzugt sind, da sich hier ein höherer Q-Faktor ergibt. Im Übrigen weisen Ausgestaltungen mit weniger Lagen vorteilhaft auch geringere Herstellungskosten auf und sind auch schon deshalb bevorzugt.

Die nachfolgende Tabelle 2 zeigt analog zur obigen Tabelle 1 drei Ausgestaltungen der Empfangsspule und deren Parameter, speziell den Q-Faktor, allerdings basieren die angegebenen Daten auf Messungen an tatsächlich gefertigten Prototypen der Platine und nicht auf einer Simulation. Die Bezeichnungen A, B, C in Tabelle 2 korrelieren nicht mit den Bezeichnungen der Tabelle 1.

Tabelle 2

| Ausgestaltung | Breite [mm] | Dicke | Induktivität [nH] | Widerstand [m$\Omega$] | Q |
|---|---|---|---|---|---|
| A | 0,3 | 2oz/70$\mu$m | 127,84 | 334,29 | 32,58 |
| B | 0,4 | 1oz/35$\mu$m | 119,15 | 424,78 | 23,90 |
| C | 0,4 | 2oz/70$\mu$m | 99,85 | 34,7 | 34,70 |

Die tatsächlichen Messwerte in Tabelle 2 berücksichtigen gegenüber Tabelle 1 auch Herstellungsparameter, wie beispielsweise die Reinheit des Kupfers, aus welchem die Leiterbahn hergestellt wird, das Material der Platine usw. Zudem ist bei den Ausgestaltungen der Tabelle 2 auch jeweils eine Ferritlage vorhanden, und zwar in zentraler Position, wie weiter unten noch genauer erläutert ist. Alle drei Ausgestaltungen A, B, C weisen zwei Leiterschleifen in zwei Lagen auf und zwei Windungen pro Leiterschleife, d.h. insgesamt vier Windungen. Deutlich erkennbar ist der große Einfluss der Dicke und der vernachlässigbare Einfluss der Breite. Aufgrund des Q-Faktors sind die Ausgestaltungen A und C allgemein bevorzugt, besonders bevorzugt ist Ausgestaltung C.

Vorteilhafterweise weist die Platine eine zusätzliche Ferritlage auf, welche die Leiterschleifen vollständig überdeckt, zur Verstärkung der Induktivität der Empfangsspule. Die Ferritlage besteht insbesondere aus einem Ferrit und ist beispielsweise mittels eines Klebstoffs, z.B. einer Klebstoffschicht, mit den übrigen Lagen verbunden, d.h. auf eine der Lagen, auf eine andere Lage oder auf das Substrat der Platine aufgeklebt. Vorzugsweise ist die Ferritlage auf eine äußere der Lagen aufgeklebt und bildet so in Stapelrichtung einen Abschluss, sodass die Empfangsspule vollständig auf lediglich einer Seite der Ferritlage angeordnet ist. Die Ferritlage ist dabei vorzugsweise auf derjenigen Seite der Empfangsspule angeordnet, welche beim kontaktlosen Laden von der Sendespule abgewandt ist. Die Ferritlage ist also gerade nicht zwischen den beiden Spulen angeordnet.

Die Ferritlage dient dazu, das Magnetfeld, welches beim kontaktlosen Laden von der Sendespule erzeugt wird, zu verstärken und die magnetische Flussdichte in der unmittelbaren Umgebung der Ferritlage zu erhöhen. Die Ferritlage ist daher vorzugsweise in unmittelbarer Nähe der Empfangsspule angeordnet, um das Magnetfeld in deren Richtung umzuleiten und zu konzentrieren und dadurch eine bessere Kopplung mit der Sendespule zu erzielen. Die Ferritlage hat auch einen Einfluss auf den Q-Faktor, welcher insbesondere durch das Material der Ferritlage bestimmt wird. Als Maß für den Verlust an Energie durch das magnetische Material der Ferritlage wird der sogenannte Verlusttangens verwendet, welcher umgekehrt proportional zu Q-Faktor ist und durch folgende Gleichung definiert ist:

$$\tan \delta = 1/Q = \mu''/\mu'$$

Dabei ist "$\tan \delta$" der Verlusttangens, $\mu''$ ist der imaginäre Anteil der komplexwertigen relativen Permeabilität und $\mu'$ ist der reelle Anteil der komplexwertigen relativen Permeabilität. Aus obiger Gleichung ergibt sich, dass geringere Verluste zu einem höheren Q-Faktor führen, d.h. zu besseren Übertragungseigenschaften. Der Verlusttangens ist typischerweise frequenzabhängig. Die Empfangsspule weist eine Resonanzfrequenz auf, vorzugsweise eine Resonanzfrequenz von 13,56 MHz. Die Resonanzfrequenz wird zur Energieübertragung genutzt. Die Sendespule weist insbesondere die gleiche Resonanzfrequenz auf wie die Empfangsspule. Bei der Resonanzfrequenz soll der Verlust möglichst gering sein, d.h. insbesondere, dass der Verlusttangens für die Resonanzfrequenz vorzugsweise geringer ist als 0,02. Die Auswahl des Materials für die Ferritlage erfolgt dann insbesondere gemäß der vorgenannten Randbedingung, d.h. die Ferritlage besteht dann aus einem Material mit einem Verlusttangens von höchstens 0,02 bei der Resonanzfrequenz der Empfangsspule.

Die Ferritlage ist vorzugsweise ebenfalls flexibel.

Allgemein gilt: je größer die Abmessungen der Ferritlage, desto größer ist die Induktivität der Empfangsspule. In jedem Fall ist es vorteilhaft, dass die Ferritlage die Leiterschleifen und die gesamte Empfangsspule vollständig überdeckt, also nicht nur teilweise. Dies basiert auf der Beobachtung, dass unterschiedliche Positionen der Ferritlage relativ zur Empfangsspule zu unterschiedlichen Induktivitäten führen. Dies ist in der nachfolgenden Tabelle 3 verdeutlicht, welche die Induktivität für verschiedene Positionen relativ zu einer zentrierten Position angibt. Die Positionen sind als Verschiebung in X- und Y-Richtung angegeben, welche senkrecht zur Stapelrichtung sind, welche zugleich eine Z-Richtung ist. In der zentrierten Position liegen die Mittelpunkte der Ferritlage und der Leiterschleifen in Stapelrichtung entlang einer Geraden und die Ferritlage reicht senkrecht zur Stapelrichtung, d.h. in X- und Y-Richtung, wenigstens derart bis zu Leiterschleifen, dass diese vollständig überdeckt sind. In Tabelle 3 ist die zentrierte Position in der Ausgestaltung A realisiert, dies zeigt auch die größte Induktivität. Die Ausgestaltungen A - I der Leiterbahn gemäß Tabelle 3 korrelieren nicht mit den Ausgestaltungen der Tabellen 1 und 2, sondern sind hiervon grundsätzlich unabhängig.

Tabelle 3

| Ausgestaltung | X-Verschiebung [mm] | Y-Verschiebung [mm] | Induktivität [nH] |
|---|---|---|---|
| A | 0 | 0 | 149,38 |
| B | 0 | 0,25 | 146,64 |
| C | 0 | 0,5 | 141,96 |
| D | 0,25 | 0 | 147,77 |
| E | 0,25 | 0,25 | 144,98 |
| F | 0,25 | 0,5 | 140,17 |
| G | 0,5 | 0 | 145,06 |
| H | 0,5 | 0,25 | 142,15 |
| I | 0,5 | 0,5 | 137,27 |

Die X- und Y-Verschiebung in den Ausgestaltungen B - I gemäß Tabelle 3 führt dazu, dass die Ferritlage die Leiterschleifen nicht mehr vollständig verdeckt und daher keine optimale Wirkung für das Magnetfeld entfaltet.

In einer zweckmäßigen Ausgestaltung weist die Platine innerhalb der Leiterschleifen eine Ausnehmung auf und die Ferritlage weist eine Erhebung auf, welche in die Ausnehmung hineinragt, sodass die Erhebung innerhalb der Windungen angeordnet ist und für die Empfangsspule einen Ferritkern bildet. Die Erhebung wird auch als "Stempel" bezeichnet, da die Erhebung von der übrigen Ferritlage in Stapelrichtung absteht und eine abgesetzte Fläche bildet, welche in den Freiraum innerhalb der Leiterschleifen hineinragt. Durch die Erhebung weist die Ferritlage allgemein mehr Material auf, wodurch die Dichte des Magnetfelds weiter erhöht wird, speziell im Zentrum der Empfangsspule. Dadurch wird die Kopplung der Spulen weiter verbessert. Die Ausnehmung ist beispielsweise in die Platine eingeschnitten und reicht vorzugsweise vollständig durch die Platine hindurch, sodass die Ausnehmung entsprechend ein Loch in der Platine bildet. Die Erhebung der Ferritlage weist insbesondere eine Umfangskontur auf, welche generell einer Innenkontur der Leiterschleifen folgt, sodass der zur Verfügung stehende Freiraum optimal genutzt und mit der Ferritlage gefüllt wird.

Vorliegend ist die Sekundärzelle zylinderförmig und weist eine Mantelfläche auf und die Platine und auch die Empfangsspule sind gebogen und folgen der Mantelfläche. In dieser Hinsicht ist es vorteilhaft, wenn die Platine wie oben bereits beschrieben flexibel ist und dadurch entsprechend biegsam ist. Beispielsweise ist die Sekundärzelle nach Art einer Knopfzelle ausgebildet und somit insgesamt zylinderförmig. Die zylinderförmige Sekundärzelle erstreckt sich allgemein in einer Längsrichtung entlang einer Längsachse. Die Mantelfläche umläuft die Längsachse und berandet die Sekundärzelle in einer radialen Richtung senkrecht zur Längsrichtung. Die Platine verläuft nun derart gebogen, dass die Platine ebenfalls um die Längsachse der Sekundärzelle gebogen ist. Die Stapelrichtung der Platine entspricht somit der radialen Richtung. Die Empfangsspule ist dann entsprechend gebogen. Auf diese Weise ist die Platine besonders platzsparend untergebracht. Gegenüber einer Anordnung der Platine auf einer Stirnfläche der Sekundärzelle ist die hier bevorzugte radiale Anordnung vorteilhaft, da diese eine freiere Gestaltung und Positionierung der Empfangsspule ermöglicht.

Zweckmäßigerweise ist zwischen der Platine und der Sekundärzelle eine Schirmlage angeordnet, welche vorzugsweise aus Kupfer besteht. Die Schirmlage dient dazu, den Gesamtwiderstand der Sekundärzelle zu verringern und auch den Einfluss des Skin-Effekts zu verringern. Üblicherweise weist die Sekundärzelle eine besonders hohe relative Permittivität auf und erzeugt durch eine Interaktion mit dem Magnetfeld starke Wirbelströme. Dadurch steigt insbesondere auch die Temperatur der Sekundärzelle. Insgesamt ergibt sich in radialer Richtung von innen nach außen gesehen eine bevorzugte Anordnung derart, dass die Sekundärzelle innen angeordnet ist, dann die Schirmlage, dann - sofern vorhanden - die Ferritlage und schließlich die Platine mit der Empfangsspule. Weiter nach außen folgt dann abschließend insbesondere noch das Gehäuse der Hörvorrichtung.

Die Hörvorrichtung ist vorzugsweise ein BTE-Hörgerät, d.h. ein Hinter-dem-Ohr-Hörgerät (BTE = behind the ear), oder ein RIC-Hörgerät, d.h. ein Hörgerät, bei welchem der Hörer im Ohrkanal getragen wird (RIC = receiver in canal). Sowohl bei einem BTE-Hörgerät als auch bei einem RIC-Gerät wird das Gehäuse von einem Nutzer hinter dem Ohr getragen und gerade nicht im Ohr, wie bei einem ITE-Gerät. Bei einem BTE-Hörgerät ist der Hörer zur Schallausgabe im Gehäuse angeordnet und ein Schallschlauch führt in getragenem Zustand vom Gehäuse ins Ohr des Nutzers. Bei einem RIC-Hörgerät ist der Hörer zu Schallausgabe dagegen außerhalb des Gehäuses angeordnet und im getragenen Zustand in den Ohrkanal eingesetzt. Der Hörer ist über eine elektrische Leitung mit dem Gehäuse verbunden.

Nachfolgend werden Ausführungsformen der Erfindung anhand einer Zeichnung näher erläutert. Darin zeigen jeweils schematisch:

Fig. 1    eine Hörvorrichtung und ein Ladegerät,
Fig. 2    ein Batteriemodul der Hörvorrichtung aus Fig. 1, mit einer Platine,
Fig. 3    eine erste Lage der Platine aus Fig. 2,
Fig. 4    eine zweite Lage der Platine aus Fig. 2,
Fig. 5    eine Leiterbahn der Platine aus Fig. 2,
Fig. 6    eine Spule,
Fig. 7    Kombination der Konzepte "Spirale" und "Helix" zur Formung einer spiralplanaren, helixförmigen Spule,
Fig. 8    ein Ausschnitt des Batteriemoduls aus Fig. 2 in einer Detailansicht,
Fig. 9    ein anderes Batteriemodul, mit einer Spule gemäß Fig. 6.

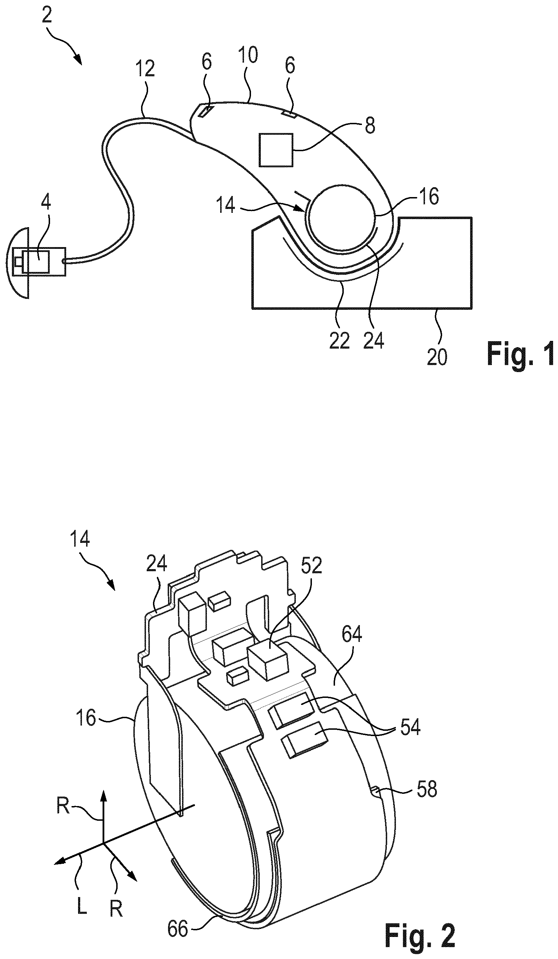

In Fig. 1 ist eine Hörvorrichtung 2 gezeigt, zur Ausgabe eines Audiosignals an einen nicht gezeigten Nutzer. Die Ausgabe erfolgt dabei mittels eines Ausgabewandlers, hier auf akustischem Weg über Luftschall mittels eines sogenannten Hörers 4. In der hier gezeigten Ausgestaltung ist die Hörvorrichtung 2 ein Hörhilfegerät, kurz auch als Hörgerät bezeichnet, zur Versorgung eines Nutzers mit einem Hördefizit. Dazu weist die Hörvorrichtung 2 wenigstens einen akustischen Eingangswandler, hier zwei Mikrofone 6, und einen Signalprozessor 8 auf. Der Signalprozessor 8 ist dazu ausgebildet, ein Eingangssignal, welches von dem Eingangswandler aus Umgebungsschall erzeugt wird, zu verarbeiten und dadurch das Hördefizit des Nutzers zumindest teilweise auszugleichen. Die Hörvorrichtung 2 weist ein Gehäuse 10 auf, in welchem diverse Komponenten untergebracht sind. Die nachfolgenden Ausführungen gelten aber grundsätzlich auch für Hörvorrichtungen 2, welche nicht speziell Hörgeräte sind.

Die in Fig. 1 gezeigt Hörvorrichtung 2 ist speziell ein RIC-Hörgerät, d.h. ein Hörgerät, bei welchem der Hörer 4 im Ohrkanal getragen wird (RIC = receiver in canal). In einer nicht explizit gezeigten Variante ist die Hörvorrichtung 2 ein BTE-Hörgerät, d.h. ein Hinter-dem-Ohr-Hörgerät (BTE = behind the ear). Sowohl bei einem BTE-Hörgerät als auch bei einem RIC-Gerät wird das Gehäuse 10 von einem Nutzer hinter dem Ohr getragen und gerade nicht im Ohr, wie bei einem ITE-Gerät. Bei einem BTE-Hörgerät ist der Hörer 4 zur Schallausgabe im Gehäuse 10 angeordnet und ein Schallschlauch führt in getragenem Zustand vom Gehäuse 10 ins Ohr des Nutzers. Bei einem RIC-Hörgerät ist der Hörer 4 zu Schallausgabe dagegen wie in Fig. 1 erkennbar außerhalb des Gehäuses 10 angeordnet und im getragenen Zustand in den Ohrkanal eingesetzt. Der Hörer 4 ist über eine elektrische Leitung 12 mit dem Gehäuse 10 verbunden.

Die Hörvorrichtung 2 weist ein Batteriemodul 14 auf, welches in Fig. 1 lediglich stark schematisiert dargestellt ist. Fig. 2 zeigt eine Ausführungsform für das Batteriemodul 14 im Detail. Das Batteriemodul 14 ist in dem Gehäuse 10 untergebracht und weist eine Sekundärzelle 16 auf, zur Energieversorgung einer oder mehrerer Komponenten der Hörvorrichtung 2. Das Batteriemodul 14 weist weiter eine Empfangsspule 18 auf, zum kontaktlosen Laden der Sekundärzelle 16. Die Empfangsspule 18 wird daher auch als Ladespule bezeichnet.

Das kontaktlose Laden erfolgt vorliegend in einem Ladebetrieb für die Hörvorrichtung 2 per Magnetfeld in einem induktiven Resonanzladeverfahren. Zum kontaktlosen Laden wird ein Ladegerät 20 verwendet, mit einer Sendespule 22, welche auch als "Primärspule" bezeichnet wird. Ein Beispiel hierfür ist stark vereinfacht in Fig. 1 erkennbar. Entsprechend wird die Empfangsspule auch als "Sekundärspule" bezeichnet. Die Empfangsspule 18 und die Sendespule 22 werden jeweils allgemein auch als Spule bezeichnet. Beim Laden wird über die Spulen 18, 22 Energie vom Ladegerät 20 zur Hörvorrichtung 2 übertragen und auf diese Weise die Sekundärzelle 16 geladen.

Das Batteriemodul 14 weist weiter eine Platine 24 auf, welche ebenfalls bereits in Fig. 1 vereinfacht dargestellt ist und in Fig. 2 genauer erkennbar ist. Die Platine 24 weist eine Leiterbahn 26 auf, welche die Empfangsspule 18 bildet. Die Platine 24 wird auch als Leiterplatte oder gedruckte Schaltung (kurz PCB, für "printed circuit board") bezeichnet. Die Leiterbahn 26 ist aus einem leitenden Material gefertigt, hier Kupfer, und auf einem Substrat 28 der Platine aufgetragen oder in das Substrat 28 eingebettet oder beides.

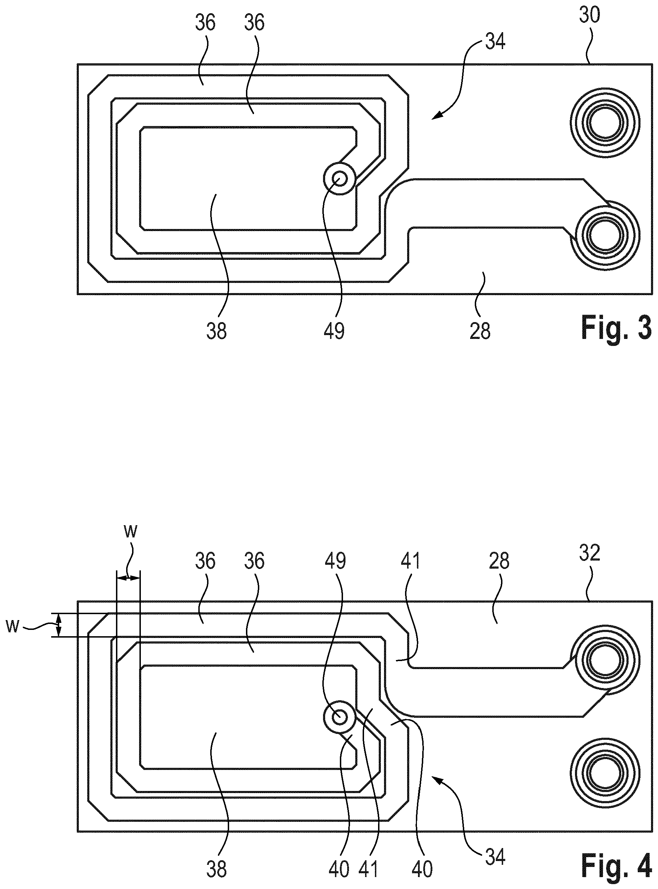

Die Platine 24 weist mehrere Lagen 30, 32 auf, wobei eine einzelne Lage 30, 32 (Englisch: layer) auch als Schicht bezeichnet wird. Der Begriff "Lage" kennzeichnet insbesondere eine einzelne Ebene, welche eine oder mehrere Leiterbahnen trägt. Die Platine 24 ist demnach eine mehrlagige Platine 24 mit wenigstens zwei Lagen 30, 32. Beispielsweise bilden eine Oberseite 30 wie in Fig. 3 gezeigt und eine Unterseite 32 wie in Fig. 4 gezeigt jeweils eine Lage 30, 32, sodass die Platine 24 eine doppelseitige Platine 24 ist. In einer nicht explizit gezeigten Variante weist die Platine 24 mehr als zwei Lagen 30, 32 auf und ist dann eine sogenannte Mehrlagenplatine 24. Die Lagen 30, 32 sind in einer Stapelrichtung S übereinandergestapelt. Die Wie aus den Fig. 2 bis 4 erkennbar ist, ist die Platine 24 insgesamt flach, d.h. plattenartig, ausgebildet. Die Platine 24 ist entweder plan ausgebildet oder umgeknickt, verläuft also nicht zwingend entlang einer einzelnen, planen Ebene, sondern folgt je nach Ausgestaltung der Hörvorrichtung gegebenenfalls einem umknickenden Verlauf, z.B. um sich einer Kontur im oder am Gehäuse oder einer Komponente der Hörvorrichtung anzupassen, wie in Fig. 2 erkennbar ist. Die Fig. 3 und 4 zeigen dann jeweils einen Ausschnitt der an sich abschnittsweise gebogen verlaufenden Platine 24 der Fig. 2 in einer planen Darstellung, zur besseren Übersichtlichkeit. Die hier explizit gezeigte Platine 24 ist außerdem flexibel, d.h. biegsam und elastisch, um wie in Fig. 2 gezeigt einem gebogenen Verlauf zu folgen.

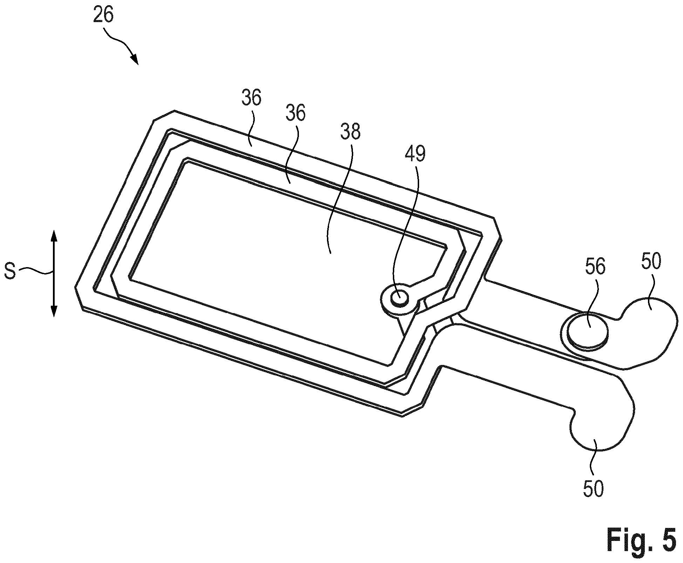

Die Leiterbahn 26 erstreckt sich über die mehreren Lagen 30, 32 und weist dabei in jeder der mehreren Lagen 30, 32 eine Leiterschleife 34 auf, mit wenigstens einer Windung 36. Auf diese Weise wird die Empfangsspule 18 gebildet, mit entsprechend vielen Windungen 36. Ein geeigneter Aufbau der Leiterbahn 26 ist den Fig. 3 und 4 zu entnehmen sowie der Fig. 5, welche die Leiterbahn 26 der Fig. 3 und 4 in einer perspektivischen Ansicht und ohne das Substrat 28 zeigt. Deutlich erkennbar ist in Fig. 5 der mehrlagige Aufbau der Leiterbahn 26 über mehrere Ebenen der Platine 24 hinweg. Die konkreten Abmessungen der Windungen 36 und deren Anordnung bestimmen dann die Übertragungseigenschaften der Empfangsspule 18. Im gezeigten Ausführungsbeispiel sind die beiden Leiterschleifen 34 der unterschiedlichen Lagen 30, 32 überwiegend gleichartig ausgebildet und weiter darüber hinaus sogar in Stapelrichtung S betrachtet überwiegend zur Deckung gebracht, wie besonders in Fig. 5 zu erkennen ist. Wie auch die Platine 24, so ist auch die Leiterbahn 26 flexibel und hierzu als flache Bahn ausgebildet.

Eine Windung 36 ist wie in den Fig. 3 bis 5 erkennbar dadurch gekennzeichnet, dass diese vollständig innerhalb einer einzelnen Lage 30, 32 verläuft. Weiter ist eine Windung 36 dadurch gekennzeichnet, dass diese eine offene Schlaufe bildet, d.h. einen Freiraum 38, d.h. Innenbereich, möglichst vollständig umringt und dabei jedoch nicht geschlossen ist. Eine jeweilige Windung 36 weist demnach zwei Enden 40, 41 auf, welche nicht miteinander verbunden sind, jedoch hier seitlich nebeneinander liegen. Die Windung 36 ist hier zudem rechteckig geformt, andere Formen sind aber grundsätzlich auch geeignet.

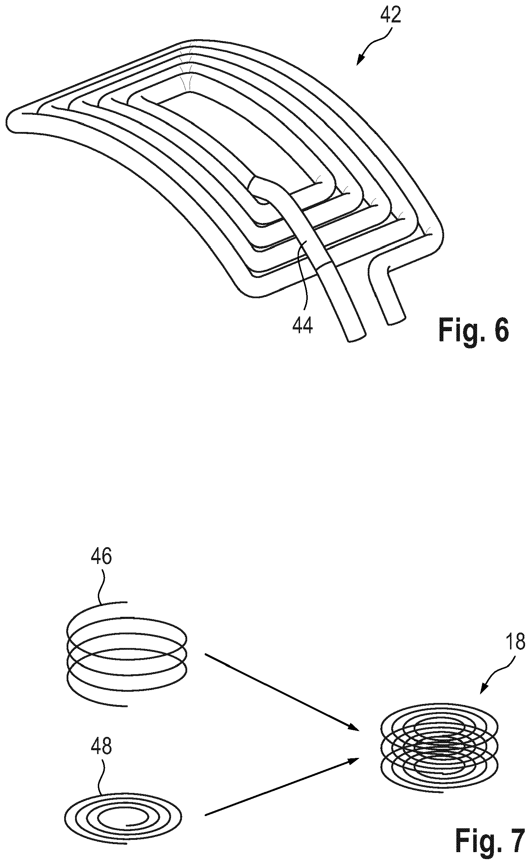

Die Verwendung einer Leiterbahn 26 als Empfangsspule 18 führt aufgrund der flachen Ausgestaltung zu einem günstigen Formfaktor, bei welchem die Empfangsspule 18 flacher ausgebildet ist als eine aus Draht gewickelte Spule 42 mit ähnlichen Übertragungseigenschaften, wie z.B. in Fig. 6 gezeigt. Speziell wird bei einer Platine 24 vermieden, dass ein endseitiger Überlapp der Leiterbahn zu einer Verdickung führt, wie dies in Fig. 6 für die Spule 42 aus Draht der Fall ist, bei welcher eines der Drahtenden aus dem Inneren der Spule 42 zum Anschließen nach außen geführt werden muss und dabei einen Überlapp 44 bildet.

Im Ausführungsbeispiel der Fig. 3 bis 5 bilden die Leiterschleifen 34 zusammen eine Helix 46 und die Windungen 36 einer jeweiligen Leiterschleife 34 bilden eine Spirale 48, sodass die Empfangsspule 16 als spiral-planare, helixförmige Spule ausgebildet ist. Das zugrunde liegende Konzept ist in Fig. 7 illustriert. Die Windungen 36 einer jeweiligen Leiterschleife 34 bilden innerhalb der entsprechenden Lage 30, 32 eine Spirale 48. Dadurch, dass sich die Leiterbahn 34 über mehrere Lagen 30, 32 erstreckt, ist dann eine Helix 46 ausgebildet. Insgesamt sind also mehrere Spiralen 48 in Stapelrichtung S übereinander angeordnet und miteinander derart in Reihe verbunden, dass eine Helix 46 gebildet wird. Hierzu sind die Spiralen 48 benachbarter Lagen 30, 32 endseitig miteinander verbunden. Zur Ausbildung einer Helix 46 werden wenigstens zwei Leiterschleifen 34, d.h. zwei Lagen 30, 32 benötigt. Zur Ausbildung einer Spirale 38 werden wenigstens zwei Windungen 36 innerhalb einer Lage 30, 32 benötigt.

In der hier gezeigten Ausgestaltung weist die Empfangsspule 18 genau zwei Leiterschleifen 34 mit jeweils genau zwei Windungen 36 auf, sodass insgesamt vier Windungen 36 vorhanden sind, welche auf zwei Lagen 30, 32 verteilt sind. Die Herstellung der Platine 24 erfolgt bei lediglich zwei Lagen 30, 32 beispielsweise derart, dass je auf Oberseite 30 und Unterseite 32 der Platine 24 eine Leiterschleife 34 ausgebildet wird, wie in den Fig. 3 und 4 gezeigt.

Die Leiterschleifen 34 sind vorliegend mittels einer Durchkontaktierung 49 (auch als "via" bezeichnet) leitend verbunden und seriell verschaltet. Die Durchkontaktierung 49 ist deutlich erkennbar in Fig. 5 und in das Substrat 28 der Platine 24 eingebettet und reicht so von einer Lage 30 zur benachbarten Lage 32. Die Durchkontaktierung 49 erstreckt sich dabei in Stapelrichtung S und somit senkrecht zu den Lagen 30, 32. Je zwei Leiterschleifen 34 sind mit einer Durchkontaktierung 49 leitend verbunden, sodass sich insgesamt eine Reihenschaltung der Leiterschleifen 34 ergibt. Aufgrund der Windungen 36 weist eine jeweilige Leiterschleife 34 ein inneres Ende 40 und ein äußeres Ende 41 auf und mittels einer jeweiligen Durchkontaktierung 49 sind dann immer zwei innere Enden 40 oder zwei äußere Enden 41 miteinander verbunden. Die zwei verbleibenden Enden 40, 41 der obersten und untersten Leiterschleife 34 sind dann mit je einem Anschlusskontakt 50 verbunden, zum Anschließen der Spule 18 z.B. an die Sekundärzelle 16, an eine Wandlerelektronik 52, an eine Ladeelektronik 54 oder eine Kombination hiervon. Generell weist die Platine 24 zwei Anschlusskontakte 50 auf, welche je mit einem Ende der Leiterbahn 26 verbunden sind, um die Empfangsspule 18 anzuschließen. Die Anschlusskontakte 50 sind im gezeigten Ausführungsbeispiel wie in Fig. 5 erkennbar gemeinsam in der Lage 30 der Platine 24 angeordnet, hierzu ist für zumindest einen der Anschlusskontakte 50 eine Durchkontaktierung 56 vorhanden, welche diesen Anschlusskontakt 50 mit einem Ende der Leiterbahn 26 in der anderen Lage 32 verbindet.

Die Hörvorrichtung 2 weist eine Ladeelektronik 54 auf, zur Steuerung des Ladevorgangs für die Sekundärzelle 16. Alternativ oder zusätzlich weist die Hörvorrichtung 2 eine Wandlerelektronik 52 auf, zur Spannungswandlung, um geeignete Spannungswerte für die elektronischen Komponenten zu realisieren. Die Ladeelektronik 54 oder die Wandlerelektronik 52 oder beide sind in Fig. 2 als integrierte Schaltungen oder Schaltkreise oder in vergleichbarer Weise als Teil der Platine 24 realisiert und somit Teil des Batteriemoduls 14.

Im gezeigten Ausführungsbeispiel weist die Leiterbahn 26 eine Breite w im Bereich von 200 μm bis 500 μm auf und eine Dicke d im Bereich von 10 μm bis 100 μm. Diese Abmessungen ergeben geeignete Übertragungseigenschaften. Die Leiterbahn 26 weist vorliegend zudem einen rechteckigen Querschnitt auf, wobei dann die Breite w entlang der Lage 30, 32 gemessen ist und die Dicke d senkrecht zur Lage 30, 32.

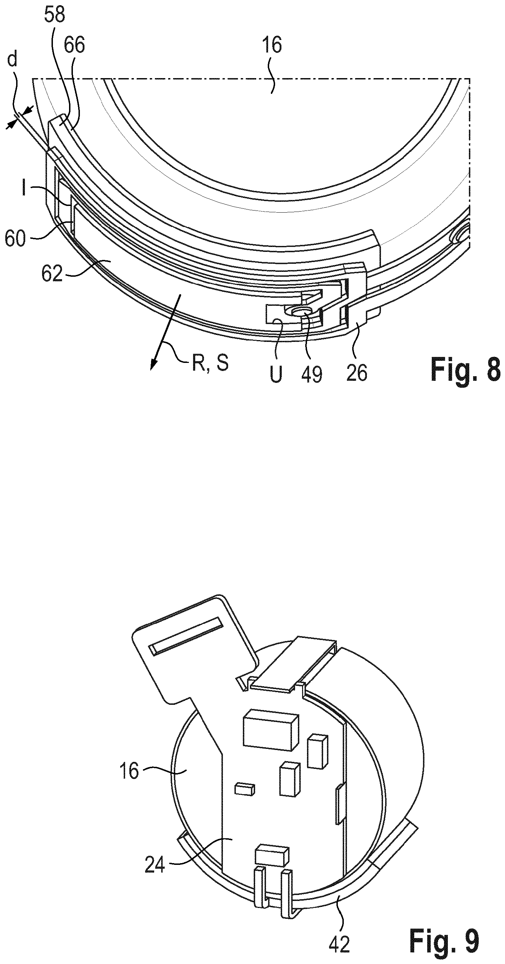

Optional weist die Platine 24 eine zusätzliche Ferritlage 58 auf, welche die Leiterschleifen 34 vollständig überdeckt, zur Verstärkung der Induktivität der Empfangsspule 18. Ein Ausführungsbeispiel mit Ferritlage ist bereits in Fig. 2 gezeigt. In Fig. 8 ist eine Detailansicht des Ausführungsbeispiels der Fig. 2 gezeigt, darin sind besonders deutlich die Leiterbahn 26 und die Ferritlage 58 erkennbar. Die Ferritlage 58 besteht insbesondere aus einem Ferrit und ist vorliegend mittels eines Klebstoffs mit den übrigen Lagen 30, 32 verbunden. Die Ferritlage 58 ist hier auf eine äußere der Lagen 30, 32 aufgeklebt und bildet so in Stapelrichtung S einen Abschluss, sodass die Empfangsspule 18 vollständig auf lediglich einer Seite der Ferritlage 58 angeordnet ist. Die Ferritlage 58 ist dabei auf derjenigen Seite der Empfangsspule 18 angeordnet, welche beim kontaktlosen Laden von der Sendespule 22 abgewandt ist. Die Ferritlage 58 ist also gerade nicht zwischen den beiden Spulen 18, 22 angeordnet.

Die Ferritlage 58 dient dazu, das Magnetfeld, welches beim kontaktlosen Laden von der Sendespule 22 erzeugt wird, zu verstärken und die magnetische Flussdichte in der unmittelbaren Umgebung der Ferritlage 58 zu erhöhen. Die Ferritlage 58 ist daher wie in Fig. 2 und 8 gezeigt in unmittelbarer Nähe der Empfangsspule 18 angeordnet, um das Magnetfeld in deren Richtung umzuleiten und zu konzentrieren. Die Empfangsspule 18 weist eine Resonanzfrequenz auf, welche zur Energieübertragung genutzt. Die Sendespule 22 weist die gleiche Resonanzfrequenz auf wie die Empfangsspule 18. Bei der Resonanzfrequenz soll der Verlust möglichst gering sein. Die Auswahl des Materials für die Ferritlage 58 erfolgt dann gemäß einer geeigneten Randbedingung. Die Ferritlage 58 ist vorzugsweise ebenfalls flexibel.

Im gezeigten Ausführungsbeispiel überdeckt die Ferritlage 58 die Leiterschleifen 34 und die gesamte Empfangsspule 18 vollständig, also nicht nur teilweise. Bei einer Verschiebung der Ferritlage 58 würden die Leiterschleifen 34 nicht mehr vollständig verdeckt und dann auch keine optimale Wirkung für das Magnetfeld mehr erzielt.

Wie in Fig. 8 erkennbar ist, weist die Platine 24 in der dort gezeigten Ausgestaltung innerhalb der Leiterschleifen 34 eine Ausnehmung 60 auf und die Ferritlage 58 weist eine Erhebung 62 auf, welche in die Ausnehmung 60 hineinragt, sodass die Erhebung 62 innerhalb der Windungen 36 angeordnet ist und für die Empfangsspule 18 einen Ferritkern bildet. Die Erhebung 62 wird auch als "Stempel" bezeichnet, da die Erhebung 62 von der übrigen Ferritlage 58 in Stapelrichtung S absteht und eine abgesetzte Fläche bildet, welche in den Freiraum 38 innerhalb der Leiterschleifen 34 hineinragt. Die Erhebung 62 der Ferritlage 58 gemäß Fig. 8 weist zusätzlich eine Umfangskontur U auf, welche generell einer Innenkontur I der Leiterschleifen 34 folgt, sodass der zur Verfügung stehende Freiraum 38 optimal genutzt und mit der Ferritlage 58 gefüllt wird.

Die hier gezeigte Sekundärzelle 16 ist zylinderförmig und weist eine Mantelfläche 64 auf. Die Platine 24 und auch die Empfangsspule 18 sind gebogen und folgen der Mantelfläche 64, wie besonders in Fig. 2 zu erkennen ist. Die zylinderförmige Sekundärzelle 18 erstreckt sich allgemein in einer Längsrichtung entlang einer Längsachse L. Die Mantelfläche 64 umläuft die Längsachse L und berandet die Sekundärzelle 18 in einer radialen Richtung R senkrecht zur Längsrichtung. Die Platine 24 verläuft nun derart gebogen, dass diese ebenfalls um die Längsachse L der Sekundärzelle 18 gebogen ist. Die Stapelrichtung S der Platine 24 entspricht somit der radialen Richtung R. Die Empfangsspule 18 ist dann entsprechend gebogen. Auf diese Weise ist die Platine 24 besonders platzsparend untergebracht. Gegenüber einer Anordnung der Platine 24 auf einer Stirnfläche der Sekundärzelle 18, wie beispielhaft in Fig. 9 gezeigt, ist die in Fig. 2 gezeigte radiale Anordnung vorteilhaft, da diese eine freiere Gestaltung und Positionierung der Empfangsspule 18 ermöglicht. Außerdem ist es aufgrund der flachen Ausgestaltung der Platine 24 gegenüber der Spule 42 möglich, die Empfangsspule 18 und die Platine 24 gemeinsam entlang der Mantelfläche 64 anzuordnen, was bei der Spule 42 in Fig. 9 nicht möglich ist.

Optional ist zwischen der Platine 24 und der Sekundärzelle 18 eine Schirmlage 66 angeordnet, welche in Fig. 2 deutlich erkennbar ist und dort beispielhaft aus Kupfer besteht. Insgesamt ergibt sich dann in Fig. 2 in radialer Richtung R von innen nach außen gesehen eine Anordnung derart, dass die Sekundärzelle 18 innen angeordnet ist, dann die Schirmlage 66, dann die Ferritlage 58 und schließlich die Platine 24 mit der Empfangsspule 18. Weiter nach außen folgt dann abschließend noch das Gehäuse 10 der Hörvorrichtung 2.

Bezugszeichenliste

2    Hörvorrichtung
4    Hörer
6    Mikrofon
8    Signalprozessor

10 Gehäuse
12 elektrische Leitung
14 Batteriemodul
16 Sekundärzelle
18 Empfangsspule, Spule
20 Ladegerät
22 Sendespule, Spule
24 Platine
26 Leiterbahn
28 Substrat (der Platine)
30 Oberseite, Lage
32 Unterseite, Lage
34 Leiterschleife (der Leiterbahn)
36 Windung (einer Leiterschleife)
38 Freiraum
40 inneres Ende (einer Windung)
41 äußeres Ende (einer Windung)
42 Spule
44 Überlapp
46 Helix
48 Spirale
49 Durchkontaktierung
50 Anschlusskontakt
52 Wandlerelektronik
54 Ladeelektronik
56 Durchkontaktierung (für den Anschlusskontakt)
58 Ferritlage
60 Ausnehmung
62 Erhebung (der Ferritlage)
64 Mantelfläche (der Sekundärzelle)
66 Schirmlage
d Dicke (der Leiterbahn)
I Innenkontur (einer Leiterschleife)
L Längsachse
R radiale Richtung
S Stapelrichtung
U Umfangskontur (der Erhebung)
w Breite (der Leiterbahn)

**Patentansprüche**

1. Hörvorrichtung (2), welche ein Batteriemodul (14) aufweist,

   - wobei das Batteriemodul (14) eine Sekundärzelle (16) aufweist,
   - wobei das Batteriemodul (14) eine Empfangsspule (18) aufweist, zum kontaktlosen Laden der Sekundärzelle (16),
   - wobei das Batteriemodul (14) eine Platine (24) aufweist, mit einer Leiterbahn (26), welche die Empfangsspule (18) bildet,
   - wobei die Platine (24) mehrere Lagen (30, 32) aufweist, welche in einer Stapelrichtung übereinandergestapelt sind,
   - wobei die Leiterbahn (26) sich über die mehreren Lagen (30, 32) erstreckt und dabei in jeder der mehreren Lagen (30, 32) eine Leiterschleife (34) aufweist, mit wenigstens einer Windung (36),
   - wobei die Sekundärzelle (16) zylinderförmig ist und eine Mantelfläche (64) aufweist,
   - wobei sich die Sekundärzelle (16) in einer Längsrichtung entlang einer Längsachse (L) erstreckt,
   - wobei die Mantelfläche (64) die Längsachse (L) umläuft und die Sekundärzelle (16) in einer radialen Richtung (R) senkrecht zur Längsrichtung berandet,
   **dadurch gekennzeichnet,**

- **dass** die Platine (24) und auch die Empfangsspule (18) gebogen sind und der Mantelfläche (64) folgen,
- **dass** die Platine (24) derart gebogen verläuft, dass die Platine (24) ebenfalls um die Längsachse (L) der Sekundärzelle (16) gebogen ist und somit die Stapelrichtung (S) der Platine (24) der radialen Richtung (R) entspricht.

2. Hörvorrichtung (2) nach Anspruch 1,
wobei die Leiterschleifen (34) zusammen eine Helix (46) bilden und die Windungen (36) einer jeweiligen Leiterschleife (34) eine Spirale (48) bilden, sodass die Empfangsspule (18) als spiral-planare und helixförmige Spule ausgebildet ist.

3. Hörvorrichtung (2) nach einem der Ansprüche 1 oder 2,
wobei die Empfangsspule (18) genau zwei Leiterschleifen (34) mit jeweils genau zwei Windungen (36) aufweist, sodass insgesamt vier Windungen (36) vorhanden sind, welche auf zwei Lagen (30, 32) verteilt sind.

4. Hörvorrichtung (2) nach einem der Ansprüche 1 bis 3,
wobei die Leiterschleifen (34) mittels einer Durchkontaktierung (49) leitend verbunden und seriell verschaltet sind.

5. Hörvorrichtung (2) nach einem der Ansprüche 1 bis 4,
wobei die Leiterbahn (34) eine Breite (w) im Bereich von 200 $\mu$m bis 500 $\mu$m aufweist und eine Dicke (d) im Bereich von 10 $\mu$m bis 100 $\mu$m.

6. Hörvorrichtung (2) nach einem der Ansprüche 1 bis 5,
wobei die Platine (24) eine zusätzliche Ferritlage (58) aufweist, welche die Leiterschleifen (34) vollständig überdeckt, zur Verstärkung der Induktivität der Empfangsspule (18).

7. Hörvorrichtung (2) nach Anspruch 6,
wobei die Platine (24) innerhalb der Leiterschleifen (34) eine Ausnehmung (60) aufweist und wobei die Ferritlage (58) eine Erhebung (62) aufweist, welche in die Ausnehmung (60) hineinragt, sodass die Erhebung (62) innerhalb der Windungen (36) angeordnet ist und für die Empfangsspule (18) einen Ferritkern bildet.

8. Hörvorrichtung (2) nach einem der Ansprüche 1 bis 7,
wobei diese ein BTE-Hörgerät oder ein RIC-Hörgerät ist.

9. Platine (24) für eine Hörvorrichtung (2),

- welche eine Leiterbahn (26) aufweist, welche eine Empfangsspule (18) bildet,
- welche mehrere Lagen (30, 32) aufweist, welche in einer Stapelrichtung übereinandergestapelt sind, wobei die Leiterbahn (26) sich über die mehreren Lagen (30, 32) erstreckt und dabei in jeder der mehreren Lagen (30, 32) eine Leiterschleife (34) aufweist, mit wenigstens einer Windung (36),
- wobei diese und auch die Empfangsspule (18) gebogen sind, um einer Mantelfläche (64) einer zylinderförmigen Sekundärzelle (16) zu folgen,
- welche derart gebogen verläuft, dass diese um eine Längsachse (L) gebogen ist und somit die Stapelrichtung (S) der Platine (24) einer radialen Richtung (R) senkrecht zur Längsachse entspricht.


**Claims**

1. Hearing device (2), which comprises a battery module (14),

- wherein the battery module (14) comprises a secondary cell (16),
- wherein the battery module (14) comprises a reception coil (18) for contactless charging of the secondary cell (16),
- wherein the battery module (14) comprises a circuit board (24) having a conductor track (26) which forms the reception coil (18),
- wherein the circuit board (24) comprises a plurality of layers (30, 32), which are stacked above one another in a stack direction,
- wherein the conductor track (26) extends over the plurality of layers (30, 32) while comprising a conductor loop (34), which has at least one turn (36), in each of the plurality of layers (30, 32),
- wherein the secondary cell (16) is cylindrical and has a lateral surface (64),

- wherein the secondary cell (16) extends in a longitudinal direction along a longitudinal axis (L),
- wherein the lateral surface (64) encircles the longitudinal axis (L) and bounds the secondary cell (16) in a radial direction (R) perpendicular to the longitudinal direction,

**characterized**

- **in that** the circuit board (24) as well as the reception coil (18) are curved and follow the lateral surface (64),
- **in that** the circuit board (24) has a curved profile, in such a way that the circuit board (24) is likewise curved around the longitudinal axis (L) of the secondary cell (16) and the stack direction (S) of the circuit board (24) therefore corresponds to the radial direction (R) .

2. Hearing device (2) according to Claim 1,
wherein the conductor loops (34) together form a helix (46) and the turns (36) of a respective conductor loop (34) form a spiral (48), so that the reception coil (18) is configured as a spiroplanar and helical coil.

3. Hearing device (2) according to Claim 1 or 2,
wherein the reception coil (18) comprises precisely two conductor loops (34), each having precisely two turns (36), so that there are in total four turns (36), which are distributed between two layers (30, 32).

4. Hearing device (2) according to one of Claims 1 to 3,
wherein the conductor loops (34) are conductively connected by means of a through-contact (49) and are interconnected in series.

5. Hearing device (2) according to one of Claims 1 to 4,
wherein the conductor track (34) has a width (w) in the range of from 200 $\mu$m to 500 $\mu$m and a thickness (d) in the range of from 10 $\mu$m to 100 $\mu$m.

6. Hearing device (2) according to one of Claims 1 to 5,
wherein the circuit board (24) comprises an additional ferrite layer (58), which fully covers the conductor loops (34), for amplifying the inductance of the reception coil (18).

7. Hearing device (2) according to Claim 6,
wherein the circuit board (24) comprises a recess (60) inside the conductor loops (34) and wherein the ferrite layer (58) comprises an elevation (62) which protrudes into the recess (60), so that the elevation (62) is arranged inside the turns (36) and forms a ferrite core for the reception coil (18).

8. Hearing device (2) according to one of Claims 1 to 7,
which is a BTE hearing aid or an RIC hearing aid.

9. Circuit board (24) for a hearing device (2),

- which has a conductor track (26) which forms a reception coil (18),
- which comprises a plurality of layers (30, 32), which are stacked above one another in a stack direction, wherein the conductor track (26) extends over the plurality of layers (30, 32) while comprising a conductor loop (34), which has at least one turn (36), in each of the plurality of layers (30, 32),
- wherein said circuit board as well as the reception coil (18) are curved in order to follow a lateral surface (64) of a cylindrical secondary cell (16),
- which has a curved profile, in such a way that it is curved around a longitudinal axis (L) and the stack direction (S) of the circuit board (24) therefore corresponds to a radial direction (R) perpendicular to the longitudinal axis.

**Revendications**

1. Appareil auditif (2), qui comporte un module de batterie (14),

- le module de batterie (14) comportant une cellule secondaire (16),
- le module de batterie (14) comportant une bobine de réception (18) destinée au chargement sans contact de la cellule secondaire (16),

- le module de batterie (14) comportant une carte de circuit imprimé (24) pourvue d'une piste conductrice (26) qui forme la bobine de réception (18),
- la carte de circuit imprimé (24) comportant plusieurs couches (30, 32) qui sont empilées les unes sur les autres dans le sens de l'empilement,
- la piste conductrice (26) s'étendant sur plusieurs couches (30, 32) et comportant dans chacune des plusieurs couches (30, 32) une boucle conductrice (34) pourvue d'au moins une spire (36),
- la cellule secondaire (16) étant cylindrique et comportant une surface latérale (64),
- la cellule secondaire (16) s'étendant dans une direction longitudinale suivant un axe longitudinal (L),
- la surface latérale (64) s'étendant autour de l'axe longitudinal (L) et bordant la cellule secondaire (16) suivant une direction radiale (R) perpendiculaire à la direction longitudinale,

**caractérisé en ce que**

- la carte de circuit imprimé (24) ainsi que la bobine de réception (18) sont courbés et suivent la surface latérale (64),
- la carte de circuit imprimé (24) est courbée de telle sorte que la carte de circuit imprimé (24) soit également courbée autour de l'axe longitudinal (L) de la cellule secondaire (16) et donc la direction d'empilement (S) de la carte de circuit imprimé (24) corresponde à la direction radiale (R).

2. Appareil auditif (2) selon la revendication 1,
les boucles conductrices (34) formant conjointement une hélice (46) et les spires (36) d'une boucle conductrice respective (34) formant une spirale (48) de sorte que la bobine de réception (18) soit conçue comme une bobine en forme d'hélice et de spirale plane.

3. Appareil auditif (2) selon l'une des revendications 1 ou 2,
la bobine de réception (18) comportant exactement deux boucles conductrices (34) pourvues chacune d'exactement deux spires (36), de sorte qu'il y ait au total quatre spires (36) qui sont réparties sur deux couches (30, 32).

4. Appareil auditif (2) selon l'une des revendications 1 à 3,
les boucles conductrices (34) étant raccordées de manière conductrice et montées en série au moyen d'un trou métallisé (49).

5. Appareil auditif (2) selon l'une des revendications 1 à 4,
la piste conductrice (34) ayant une largeur (w) dans la gamme allant de 200 $\mu$m à 500 $\mu$m et une épaisseur (d) dans la gamme allant de 10 $\mu$m à 100 $\mu$m.

6. Appareil auditif (2) selon l'une des revendications 1 à 5,
la carte de circuit imprimé (24) comportant une couche de ferrite supplémentaire (58) qui recouvre complètement les boucles conductrices (34) afin d'augmenter l'inductance de la bobine de réception (18).

7. Appareil auditif (2) selon la revendication 6,

- la carte de circuit imprimé (24) comportant un évidement (60) à l'intérieur des boucles conductrices (34) et la couche de ferrite (58) présentant une élévation (62) qui fait saillie dans l'évidement (60) de sorte que l'élévation (62) soit disposée à l'intérieur des spires (36) et forme un noyau de ferrite pour la bobine de réception (18).

8. Appareil auditif (2) selon l'une des revendications 1 à 7, celui-ci étant une aide auditive BTE ou une aide auditive RIC.

9. Carte de circuit imprimé (24) destinée à un appareil auditif (2),

- laquelle comporte une piste conductrice (26) qui forme une bobine de réception (18),
- laquelle comporte plusieurs couches (30, 32) qui sont empilées les unes sur les autres dans une direction d'empilement, la piste conductrice (26) s'étendant sur les plusieurs couches (30, 32) et comportant dans chacune des plusieurs couches (30, 32) une boucle conductrice (34) pourvue d'au moins une spire (36),
- celle-ci ainsi que la bobine de réception (18) étant courbées afin d'épouser une surface latérale (64) d'une cellule secondaire cylindrique (16),
- laquelle est courbée de manière à être courbée autour d'un axe longitudinal (L) et ainsi de sorte que la direction d'empilement (S) de la carte de circuit imprimé (24) corresponde à une direction radiale (R) perpendiculaire à

l'axe longitudinal.

Fig. 1

Fig. 2

**Fig. 3**

**Fig. 4**

Fig. 5

**Fig. 6**

**Fig. 7**

58
66
d
I
60
62

R, S
U    49    26

**Fig. 8**

16
24

42

**Fig. 9**

16

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2014176060 A1
- US 2013175983 A1
- US 2013127404 A1
- US 2020021127 A1
- KR 20200030786 A
- US 2013089232 A1